# EUROPEAN PATENT APPLICATION

(11) **EP 0 633 600 A1**
(43) Date of publication of application: **11.01.1995**
(21) Application number: 94110471.3
(22) Date of filing: 06.07.1994
(51) Int. Cl.: H01J 37/34, H01J 37/32, C23C 14/56

(54) **Method and apparatus for forming thin films**

(71) Applicant: APPLIED MATERIALS, INC., Santa Clara California 95054-3299 (US)
(72) Inventor: Sawada,Susumu, c/o Japan Energy Corp., Toranomon,Minato-ku, Tokyo (JP); Anan,Junichi, c/o Isohara Plant, Kitaibaraki-shi, Ibaraki-ken (JP); Wada,Hironori, c/o Isohara Plant, Kitaibaraki-shi, Ibaraki-ken (JP); Kakutani,Yoshitaka, c/o Isohara Plant, Kitaibaraki-shi, Ibaraki-ken (JP); Yanagawa,Fumihiko, c/o Applied Materials Japan Inc, Shinjuku-ku, Tokyo (JP); Mosely,Roderick Craig, c/o Applied Materials Japan, Shinjuku-ku, Tokyo (JP)
(74) Representative: Diehl, Hermann, Dr. Dipl.-Phys.

(57) **Abstract**

A thin film forming apparatus, a collimator (30) adapted to function as a particle getter is disposed between a target (22) and a wafer (32). The collimator (30) is fabricated by assembling a plurality of embossed, slitted particle getter sheets (65, 66) into a lattice (40) honeycomb, or other structure having a number of rows of openings, and fixing the assembly into a frame (41). The particle getter sheets capture and hold particles and thereby prevent particle generation that would otherwise result when deposited films peel off of the collimator surface, without deteriorating the performance of the collimator (30).

## Description

The present invention relates to the formation of thin films on substrates.

### DESCRIPTION OF THE PRIOR ART

Vapor phase growth technology is widely used to form many different types of thin films, *e.g*. thin films for the electrodes and diffusion barriers of integrated circuits, magnetic films for magnetic recording media, and clear conductive films of indium-tin oxide ( 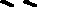 ITO'') for liquid crystal display units. Thin film formation techniques using vapor phase film growth technology include chemical vapor phase growth methods, such as thermal decomposition, hydrogen reduction, disproportionation reactions, and plasma chemical vapor deposition (CVD); physical vapor phase methods, such as vacuum vapor deposition, sputtering, and ion beam techniques; and other discharge polymerization methods. For example, in a sputtering process, a target and a substrate, such as a semiconductor wafer, are located opposite of each other, and atoms released from the target by sputtering are deposited onto the substrate to form a thin film thereon.

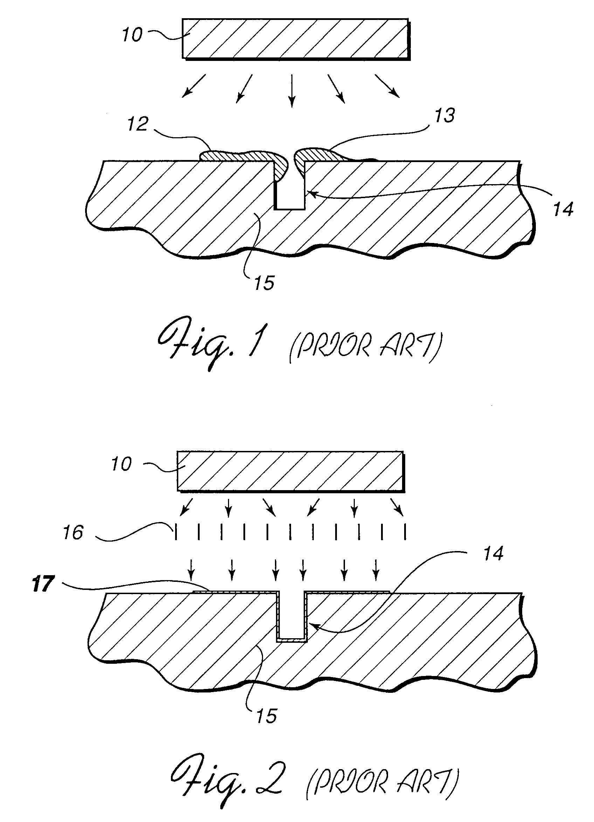

Continuing advances in the integration of electronic devices have created a need for new techniques of forming thin films. In at least one process for fabricating semiconductor devices on a semiconductor substrate, it is necessary to coat wafers having deep pits in the wafer surface with a uniform film (see Fig. 1). The coating 12,13 that is sputtered onto the wafer 15 from the target 10 must also cover the bottom surface of each pit 14. In ordinary sputtering, a majority of sputtered atoms are scattered aslant with respect to the wafer surface. The atoms are unable to travel deep into the pit, and are deposited mostly around the inlet opening of the pit. Consequently, it is not possible to form a uniform film on the wafer surface that extends to the bottom of the pit using conventional sputtering techniques.

A technique referred to as collimation sputtering is known. See, for example Japanese Patent Application Public Disclosure No. 123021/1991 (see, also Fig. 2). Collimation sputtering uses a collimator 16 that is disposed between a substrate 15 on which a film 17 is to be formed and a film forming source 10 that is held opposite to the substrate in a film forming apparatus. The collimator 16 only allows sputtered atoms to pass therethrough in the direction perpendicular to the surface of the substrate. Thus, in collimation sputtering the collimator 16 captures obliquely scattering atoms and passes only the atoms that are sputtered perpendicularly to the wafer surface. Consequently, a uniform film is formed that extends to the bottom surface of deep pits 14 formed in the surface of the wafer 15. The collimator is typically formed as a stainless steel ring having a honeycomb structure including arrays of openings that may be, for example, about 20 mm in diameter.

The above-mentioned Japanese Patent Application Public Disclosure No. 123021/1991 discloses a collimator for use in a film forming apparatus. The collimator therein comprises a plurality of tube assemblies and a collimator composed of two sets of parallel sheets arranged in series and at right angles to each other that cooperate to form the openings that direct the travel of sputtered atoms toward the surface to be coated.

Thin film forming processes, such as those discussed above which involve vapor phase growth, are currently applied to mass production techniques, but they pose a problem of deposition of coarsened or clustered particulate matter, commonly referred to as particles, on the surface of the resulting film. These particles result from various factors, including the thin film process itself and the thin film forming apparatus used. During wafer handling and processing, these particles scatter and deposit in clusters on the surface of substrates inside the apparatus. The particles are often as large as several µm in diameter, and can cause such problems as shorting or breaking of conductor lines in large scale integrated circuits, leading to an increased percentage of rejects.

A major source of the particles is the deposition of scattered particulate matter around the substrate on the inner walls of the film forming apparatus, and on components of the apparatus, such as shutters and shields. The particulate matter is deposited as a film that can peel off of the surface on which is has been deposited, scatter again, and then be deposited on the surface of the substrate, thereby contaminating the substrate.

To prevent particle generation, it is necessary that the surfaces of the inner walls and components of the film forming apparatus be kept clean. However, maintaining the cleanliness of the inner walls of the film forming apparatus is quite difficult. Complete cleaning of the film forming apparatus takes a considerable amount of time. Even if the apparatus is carefully cleaned, some portions of the film forming apparatus inner walls and component parts are practically inaccessible and cannot be cleaned.

It is known in the art to use a disposable foil, such as aluminium or electrolytic iron foil, to line the inner walls of the film forming apparatus before substrate processing. The foil is removed after substrate processing is completed, and thereby facilitates apparatus cleaning. However, the particulate material that is deposited on the foil during substrate processing comes off easily, and therefore provides yet another source of particle generation. Frequent replacement of the foil is necessary to keep the material deposited on the foil from scattering within the apparatus. Such frequent foil replacement results in significant apparatus downtime which seriously affects apparatus productivity.

The following alternatives to lining the apparatus inner walls with a disposable foil to prevent particle generation have been proposed:
(1) an electrolytic copper foil having a matte side that is electrolytically treated to deposit fine particles of copper or copper oxide at random on minute rounded protuberances or knobs that have been formed on the matte side of the foil;
(2) a treated electrolytic copper foil, as in (1) above, that is also coated with either the same material as that of the thin film that is to be formed on the substrate surface by the thin film forming apparatus, or a similar process compatible material;
(3) a metallic foil that is formed in a bellow shape;
(4) a metallic foil that has numerous protrusions and dents that are formed by embossing; and
(5) a thermally sprayed metallic film meshed on one side to add strength to the film, and to prevent the deposited material from peeling from the film.

The foregoing improved metallic foils and sprayed films, which are generically referred as particle getters ( 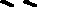 PG''), effectively prevent the generation of particles, and therefore are superior to ordinary metallic foils for capturing and holding scattered particulate matter. Thus, affixing such particle getters to the film forming apparatus inner walls and component parts, such as shutters and shields, significantly reduces particle generation and improves the yield and reliability of the resulting thin film. See, for example Japanese Patent Application Public Disclosure Nos. 87356/1991, 87357/1991, 166361/1991, and 166362/1991.

Unfortunately, in a thin film forming apparatus using a collimator, an increase in particle generation is observed when a particle getter foil is affixed to the film forming apparatus inner walls and component parts. Such increased particle generation degrades the film forming characteristics of the collimator. Although it might appear possible to attach particle getter foils to the collimator itself, to do so would impair the fundamental function of the collimator, which is to provide several small openings that direct the sputtered atoms to the substrate surface in a coherent fashion. It would be a significant advance in the art of depositing thin films using collimated sputtering techniques if the problem of particle generation within the film forming apparatus could be solved.

This object is solved by the apparatus for forming thin films according to independent claims 1 or 3 and the method of independent claim 5. Further advantageous features, aspects and details of the invention are evident from the dependent claims, the description and the drawings. The claims are intended to be understood as a first non-limiting approach of defining the invention in general terms.

The invention allows the formation of thin films using a collimator positioned between a film forming source and a substrate.

The invention reduces or prevents particle generation in a film forming apparatus that results from the peeling of deposited films formed on a collimator, without reducing the performance of the collimator. The invention provides a collimator that may be made of stainless steel sheets, and that therefore also acts as a particle getter. The invention therefore provides a collimator for a thin film forming apparatus composed of particle getter sheets. The invention also provides a thin film forming apparatus having a collimator that is composed of particle getter sheets, where the collimator is set between a film forming source and a substrate.

An exemplary collimator, formed in accordance with the invention, consists of two or more embossed, slitted particle getter sheets that are assembled in a lattice pattern. The collimator itself is therefore also a particle getter, such that the particulate matter film deposited and formed on thereon is kept from peeling off as a particle source, without impairing the function of the collimator.
Fig. 1 is a cross section showing a prior art film forming apparatus for sputtering a film onto a substrate surface, where the substrate includes several deep pits formed therein;
Fig. 2 is a cross section showing a prior art film forming apparatus for sputtering a film onto a substrate surface, where the substrate includes several deep pits formed therein, and where a uniform film is deposited on both the substrate surface and at the bottom of a deep pit by passing sputtered atoms through a collimator that directs the atoms toward the substrate surface in a direction that is perpendicular thereto;
Fig. 3 is a schematic, sectioned elevation view showing an apparatus for forming thin films by target sputtering according to the invention;
Fig. 4 is a top plan view showing a lattice collimator configured as a particle getter according to the invention;
Fig. 5 is a fragmentary perspective view of the collimator shown in Fig. 4; and
Fig. 6 shows a sequence of steps for assembling the particle getter collimator of Figs. 4 and 5, including:
   (a) forming a first particle getter sheet having central slots, and a second particle getter sheet having slits along both of its edges;
   (b) folding the two particle getter sheets of (a) above from the center; and
   (c) embossing the particle getter sheets.

The invention reduces or prevents particle generation in a film forming apparatus that results from the peeling of deposited films formed on a collimator. The invention provides a collimator that acts as a particle getter and that therefore may be made of stainless steel sheets. Making the collimator itself a particle getter prevents films deposited on the collimator from peeling off and becoming a particle source, without impairing the function of the collimator.

The term "thin film forming equipment" as used herein refers generally to an apparatus for forming thin films on substrates using a vapor growth method, for example chemical vapor deposition ( 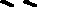 CVD''), such as decompression CVD; thermal decomposition; hydrogen reduction; disproportion reaction; transport reaction; plasma CVD; vapor phase epitaxial ( 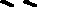 VPE''); vacuum deposition; sputtering; molecular beam epitaxy ( 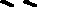 MBE''); and physical vapor deposition ( 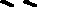 PVD''), such as the ion beam method.

The term "particle getter plate" as used herein refers to materials that have sufficient structural strength that they may be used to form a collimator that is also a particle getter, *i.e.* a collimator that has a surface that captures and holds particles. Such materials may include, for example:
(1) treated electrolytic copper plates;
(2) treated electrolytic copper plates that are coated with a material that is identical to the thin film to be formed on the substrate in the thin film forming apparatus, or that are coated with a similar process compatible material;
(3) bellows-shaped metallic plates;
(4) embossed metallic plates;
(5) combinations of (1) or (2) and (3) or (4) above;
(6) metal coated plates;
(7) electrolytic nickel plates; and
(8) electrolytic stainless steel ( 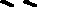 SUS'') sheets.

The treated electrolytic copper plate referred to above is a treated electrolytic copper plate having a matte or rough surface, *i.e.* a non-glossy surface, that has knob shaped protuberances formed thereon, upon which fine grains of copper or copper oxide are randomly precipitated. The fine grains or nodules of copper or copper oxide that are precipitated on the knob shaped rough surface of the copper plate may be observed with an electronic microscope.

A typical process for performing such electrolytic treatment of the copper plate is as follows:
(a) Water soluble copper sulfate plating bath

| | |
|---|---|
| CuS0₄ · 5H₂O, g/l (as Cu) | 23 |
| NaCl, ppm (as Cl) | 32 |
| H₂SO₄, g/l | 70 |
| Glue, g/l | 0.75 |
| Pure water | remaining part |

(b) Plating condition

| | |
|---|---|
| Current density | 0.6-0.97 A/m³ (60-100 A/ft³) |
| Bath temperature | 21-26.4°C (70-80°F) |
| Time | 10-100 sec |

The exemplary treated electrolytic copper plate may have a surface roughness Rz of about 5.0-10.0 µm. Such surface roughness provides a plate having a surface that appears to have protrusions projecting therefrom that increase surface area of the plate, such that scattered particulate materials deposited on the plate surface are anchored thereto. Thus, the surface roughness promotes adhesion of the deposited film to the plate surface, such that particle generation is reduced, if not entirely eliminated.

The treated electrolytic copper plate may also be coated with a material having a composition that is identical to that of the thin film that is to deposited on the substrate surface, or it may be coated with a similar, process compatible material. The coating is typically a film, such as an oxide, silicide, alloy, or metal, that is deposited by vapor growth or another method, and that may have a thickness of about 100 nm-10,000 nm (about 1,000-100,000 Å). The coating is thought to prevent contamination of the film forming apparatus that may originate in the copper plate.

A bellows-shaped metallic plate may be used to increase significantly the surface area of the collimator and thereby reduce cracking of the deposited film. A bellows-shaped collimator may be formed from a metallic plate, for example a copper, nickel, or stainless steel plate. The plate may be given a bellows shape by form processing, such as roll forming. Such shaping reduces the quantity of deposited film that must be adhered to the collimator surface per unit area, thereby reducing internal stress in the film, and accordingly reducing the likelihood that the film can crack and peel.

An embossed metallic plate may also be used to form the collimator. Such an embossed metal plate may include regular or random surface irregularities that are produced by form processing, such as press processing or roll forming. The surface area of the plate is noticeably increased by embossing,. This reduces the quantity of deposited film that must be adhered to the collimator per unit area, thereby reducing internal stress in the film, and accordingly reducing the likelihood that the film can crack and peel.

A thermally sprayed metallic sheet may also be used to take advantage of the surface irregularities that are formed when the metallic sheet is sprayed. These irregularities produce an anchoring effect, and thus improve adhesion of the deposited film to the surface of the collimator.

It should be appreciated that it is possible to improve further the function of the collimator as a particle getter by applying the bellows shaping or embossment techniques discussed above to various other materials, for example a treated electrolytic copper plate, an electrolytic nickel plate, or an electrolytic SUS plate.

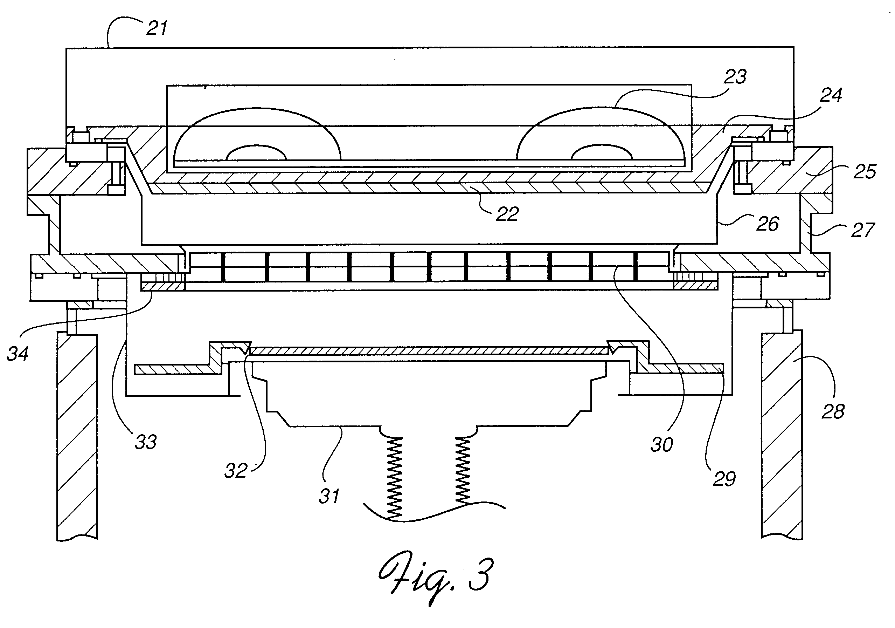

Figure 3 is a schematic, sectioned elevation view showing an apparatus for forming thin films by target sputtering according to the invention. The figure shows a portion of a thin film forming apparatus, such as is used for target sputtering in accordance with the invention. In the figure, a target 22 and a substrate 32, for example a silicon wafer, are arranged within the thin film forming apparatus. The target 22 is adhered to a backing plate 24, and is fixed to an adapter ring 25 that is, in turn, provided on a spacer ring 27. The substrate 32 is held by a clamp ring 29. The substrate is heated during processing by a heater 31 that is situated within a sputter chamber 33. Magnets 23 that are used during substrate processing are positioned at the backside of the target 22. The magnets are cooled by cold water provided by a cold water cover 21.

A collimator 30 that is adapted to function as a particle getter is situated between the target and the substrate. The collimator 30 is secured by a collimator holder 28. The collimator 30 has a plurality of apertures formed therethrough, referred to as collimator cells, that are adapted to orient atoms sputtered from the target, such that the atoms are directed toward the substrate surface in a trajectory that is perpendicular thereto.

A top shield 26 is positioned between the target and the collimator, and a bottom shield 34 is positioned between the collimator and the wafer. Of the atoms sputtered from target 22, only those atoms having a trajectory that is vertical relative to the substrate surface pass through the collimator, while atoms that scatter aslant to the substrate surface are captured by collimator and held thereto during substrate processing.

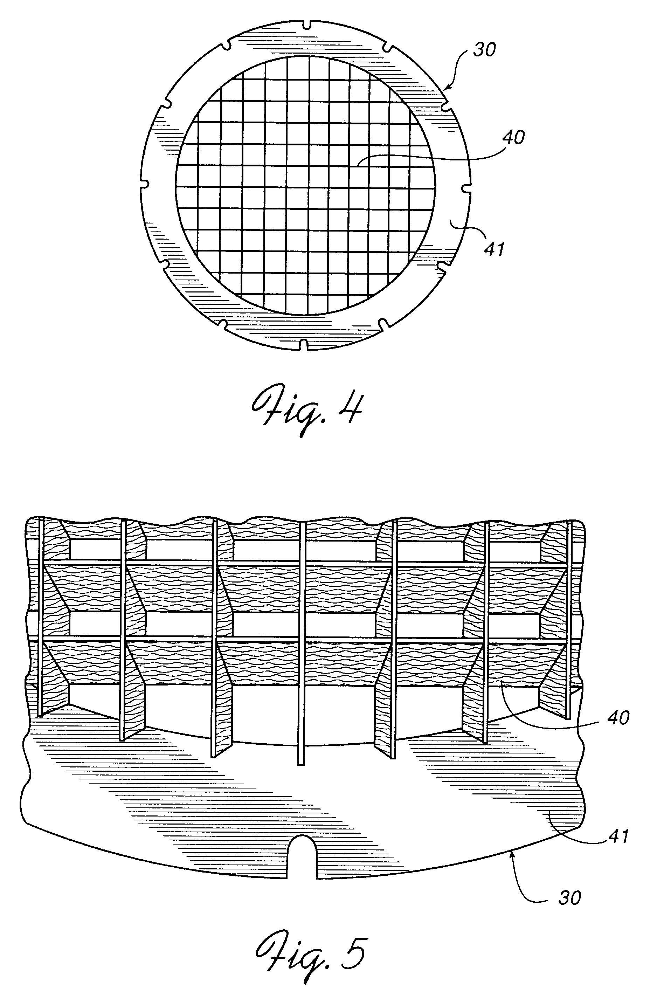

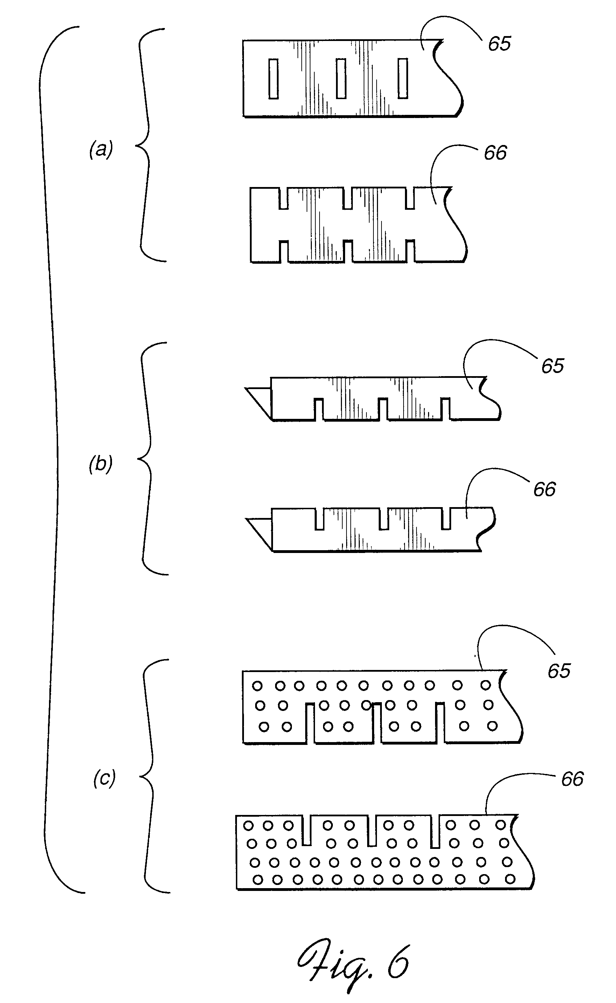

Figure 4 is a top plan view showing a lattice collimator configured as a particle getter according to the invention. The collimator 30 comprises a lattice formed of intersecting, embossed particle getter plates 40 that are secured to a frame 41. Figure 5 is a fragmentary perspective view of the collimator shown in Figure 4.

Fig. 6 shows a sequence of steps for assembling the particle getter collimator of Figs. 4 and 5, including:
(a) forming a first particle getter sheet having central slots, and a second particle getter sheet having slits along both of its edges;
(b) folding the two particle getter sheets of (a) above from the center; and
(c) embossing the particle getter sheets.

A plurality of particle getter plates are formed as is shown in Fig. 6 at (a). A first set of particle getter plates 65 have holes apertures or slots formed therethrough having a width that is at least slightly larger than and preferably at least twice as large as the particle getter plate thickness (generally 2-3 mm). In the exemplary embodiment of the invention, the apertures or slots are formed at intervals of about 15-30 mm. The first particle getter plates 65 comprise one side of a collimator cell.

A second set of particle getter plates plate 66 have slits formed in each edge. The slits are of at least a slightly larger width than the particle getter plate thickness and are preferably at least twice as large as the plate thickness, and are formed at intervals that correspond to the slot positions of the first set of particle getter plates 65. The second particle getter plates 66 comprise a second side of a collimator cell. Both the slits and the slots may be formed by known methods, for example by a laser.

As shown in Fig. 6 at (b), the first particle getter plate 65 and the second particle getter plate 66 are each folded lengthwise with the particle getter surface oriented to the outer plate surface. Folding the first particle getter plate 65 aligns two halves of the slots such that the folded edge of the plate is slitted. Folding the second particle getter plate 66 aligns the two edge slits such that the plate has a single slitted edge.

As shown in Fig. 6 at (c), the folded first and second particle getter plates 65, 66 are embossed, for example by roll processing. As a result of the foregoing, two processed particle getter plates are provided having one outer surface that includes concave-surface embossments, having another outer surface that includes complementary convex-surface embossments, and in which the two inner surfaces of each plate are in abutting contact that extends to the edges of the plate from the folded edge.

The two processed plates are assembled into a lattice-shaped collimator by interlocking the slits formed in the plate edges, as shown in Fig. 5. The plates that comprise the assembled collimator may then be permanently secured, for example by spot welding, to the stainless steel frame 41 such that the folded edges of the plates are arranged in the scattering direction of the sputtered atoms. In this way, it is unlikely that particles can accumulate in any gap that may otherwise be present along the edge of the plates opposite the folded edge, nor is it likely that sputtered atoms will be trapped in such gap.

It should be appreciated that the collimator of the invention is not limited to the foregoing manufacturing method. For example, the invention may be practised using particle getter plates in which the slots are not formed by folding the plates in two as described above, nor is it necessary that the plates intersect at a right angle. For example, it is within the scope of the invention to bend the particle getter plates to form aperture groups having a triangular shape, square shape, and/or pentagonal shape. The plates so formed may then be assembled, for example by spot welding. It is also within the scope of the invention to assemble round or square tubes formed from the particle getter plate material, and then cut the tubes into any desired length as may be necessary to form a collimator. Alternatively, one may form an assembled cubic body with lattice or honeycomb structure from copper, stainless steel, or nickel plates, and then form electrodeposited particle getter materials on the body surface by such techniques as electrolysis.

In operation, the collimator herein is arranged within the film forming apparatus between the substrate and the target. Particle getter foil may be also used in the film forming apparatus in a conventional manner, for example on the apparatus top and bottom shields, and side walls.

### Example

A lattice-shaped collimator processed to provide a particle getter function as shown in Fig. 4 and 5 was manufactured. Several electrolytic copper foil particle getter plates having a width of 40 mm, and upon which copper was electrodeposited were prepared. A first set of particle getter plates were prepared having slots formed therethrough with a dimension of 20 mm x 2.5 mm at the center at a 20 mm pitch; and a second set of particle getter plates were prepared having slits formed at both edges with a dimension of 2.5 mm at both edges at a 20 mm pitch, such that the slits of the second particle getter plate are arranged for complementary engagement with the slots of the first particle getter plate. The slots and slits were both laser cut processed.

The two cut processed particle getter plates were folded lengthwise such that the particle getter processed surface was on the outside of each plate. The plates were then embossed in an embossment processor by roll processing, such that the embossed particle getter plates had one surface of convex embossments and one surface of concave embossments, and in which the two inner particle getter plate surfaces adhere closely from the folded edge.

The partially slit embossed particle getter plates were next assembled to form a collimator having a lattice shape. Finally, the formed assembled collimator was fixed to a stainless steel (SUS 77) ring-shaped frame by spot welding, such that the plate folded edges were oriented in the scattered direction of the atoms.

The collimator thus formed was placed in service in a sputtering thin film forming apparatus, model: E5500 made by Applied Materials Inc. of Santa Clara, California, and the collimator performance was then evaluated. Particle generation attributable to peeling of a deposited film from the collimator was to 1/2-1/3 of that encountered using conventional collimators. It can be seen that with the invention it is possible to prevent the peeling of deposited films from the collimator without decreasing the function of the collimator, and thus reduce the particle generation and the impact such particle generation has on the quality of thin films formed in the thin film forming apparatus. Thus, the invention greatly improves product yield and reliability.

## Claims

1. A thin film forming apparatus comprising a film forming source (22), a collimator (30) and a substrate (32) characterised in that the collimator (30) comprises:
a plurality of particle getter sheets (40) are situated between said film forming source (22) and the substrate (32).

2. The apparatus of Claim 1, wherein the collimator (30) comprises:
a plurality of embossed, slitted particle getter sheets (65, 66) assembled in a lattice pattern.

3. A collimator for a thin film forming apparatus, comprising:
a plurality of particle getter sheets (40).

4. The collimator of Claim 3, comprising:
a plurality of embossed slitted particle getter sheets (65, 66) assembled in a lattice pattern.

5. A method for preventing particle generation in a thin film forming apparatus having a film forming source, comprising the step of:
situating a plurality of particle getter sheets between said film forming source and a substrate.

6. The method of Claim 5, further comprising the step of:
assembling a plurality of embossed, slitted particle getter sheets in a lattice pattern.
